# EUROPÄISCHE PATENTSCHRIFT

(11) **EP 2 092 642 B1**
(45) Veröffentlichungstag und Bekanntmachung des Hinweises auf die Patenterteilung: **19.10.2011**
(21) Anmeldenummer: 08716873.8
(22) Anmeldetag: 15.02.2008
(51) Int. Cl.: H03K 3/53, H05B 41/30

(54) **HOCHSPANNUNGSPULSGENERATOR UND HOCHDRUCKENTLADUNGSLAMPE MIT DERARTIGEM GENERATOR**
HIGH-VOLTAGE PULSE GENERATOR AND HIGH-PRESSURE DISCHARGE LAMP COMPRISING SUCH A GENERATOR
GÉNÉRATEUR D'IMPULSIONS À HAUTE TENSION ET LAMPE À DÉCHARGE À HAUTE PRESSION POURVUE D'UN TEL GÉNÉRATEUR

(30) Priorität: 06.03.2007 DE 102007010899
(43) Veröffentlichungstag der Anmeldung: 26.08.2009
(73) Patentinhaber: OSRAM Gesellschaft mit beschränkter Haftung, 81543 München (DE)
(72) Erfinder: KLOSS, Andreas, 85579 Neubiberg (DE); LIEPOLD, Ute, 80939 München (DE); WALTER, Steffen, 85667 Oberpframmern (DE)
(86) Internationale Anmeldenummer: PCT/EP2008/051866
(87) Internationale Veröffentlichungsnummer: WO 2008/107294

(56) Entgegenhaltungen:
- US-A- 4 353 012
- US-A- 4 484 085
- US-A- 4 629 945

## Beschreibung

### Technisches Gebiet

Die Erfindung geht aus von einem Hochspannungspulsgenerator gemäß dem Oberbegriff des Anspruchs 1. Derartige Generatoren lassen sich insbesondere für Hochdruckentladungslampen für Allgemeinbeleuchtung oder für fotooptische Zwecke oder für Kfz einsetzen. Die Erfindung betrifft weiterhin eine Hochdruckentladungslampe, die mit einem derartigen Generator ausgestattet ist.

### Stand der Technik

Das Problem der Zündung von Hochdruckentladungslampen wird derzeit dadurch gelöst, dass das Zündgerät in das Vorschaltgerät integriert ist. Nachteilig daran ist, dass die Zuleitungen hochspannungsfest ausgelegt sein müssen.

In der Vergangenheit hat es immer wieder Versuche gegeben, die Zündeinheit in die Lampe zu integrieren. Dabei wurde versucht, sie in den Sockel zu integrieren. Eine besonders effektive und hohe Pulse versprechende Zündung gelingt mittels sog. Spiral-Puls-Generatoren, siehe US-A 3 289 015 und US 4 484 085. Vor längerer Zeit wurden derartige Geräte bei verschiedenen Hochdruckentladungslampen wie Metallhalogenidlampen oder Natriumhochdrucklampen vorgeschlagen, siehe beispielsweise US-A 4 325 004, US-A 4 353 012. Sie konnten sich jedoch nicht durchsetzen, weil sie zum einen zu teuer sind. Zum andern ist der Vorteil, sie in den Sockel einzubauen, nicht ausreichend, da das Problem des Zuführens der Hochspannung in den Kolben bleibt. Daher die Wahrscheinlichkeit für Schädigungen der Lampe, seien es Isolationsprobleme oder ein Durchbruch im Sockel, steigt stark an. Bisher übiche Zündgeräte konnten Im allgemeinen nicht über 100 °C erwärmt werden. Die erzeugte Spannung musste dann der Lampe zugeführt werden, was Leitungen und Lampenfassungen mit entsprechender Hochspannungsfestigkeit erfordert, typisch etwa 5 kV.

### Darstellung der Erfindung

Die Aufgabe der vorliegenden Erfindung ist es, einen kompakten Hochspannungspulsgenerator anzugeben.

Diese Aufgabe wird gelöst durch die kennzeichnenden Merkmale des Anspruchs 1.

Besonders vorteilhafte Ausgestaltungen finden sich in den abhängigen Ansprüchen.

Weiterhin ist eine Aufgabe der vorliegenden Erfindung, eine Hochdruckentladungslampe bereitzustellen, deren Zündverhalten gegenüber bisherigen Lampen deutlich verbessert ist und bei der keine Schädigung infolge der Hochspannung zu befürchten ist. Dies gilt insbesondere für Metallhalogenidlampen, wobei das Material des Entladungsgefäßes entweder Quarzglas oder Keramik sein kann. Diese Aufgabe wird durch die kennzeichnenden Merkmale des Anspruchs 14 gelöst.

Erfindungsgemäß wird jetzt ein Hochspannungspuls mit mindestens 1,5 kV, der zur Zündung der Lampe notwendig ist, mittels eines speziellen temperaturresistenten Spiral-Puls-Generators erzeugt, der in unmittelbarer Nähe des Entladungsgefäßes im Außenkolben integriert wird. Nicht nur eine Kaltzündung sondern auch ein Heißwiederzündung ist damit möglich.

Der jetzt verwendete Spiral-Puls-Generator ist insbesondere ein sog. LTCC-Bauteil oder HTCC-Bauteil. Damit ist gemeint, dass es aus LTCC-fähiger (Low Temperature Co-fired Ceramics) bzw. aus HTCC-fähiger (High anstatt Low) Keramik hergestellt ist. Dieses Material beschreibt eine spezielle Keramik, die bis 600 °C temperaturfest gemacht werden kann. Zwar wurde LTCC schon in Zusammenhang mit Lampen verwendet, siehe US 2003/0001519 und US-B 6 853 151. Jedoch wurde es für ganz andere Zwecke bei praktisch kaum temperaturbelasteten Lampen, mit typischen Temperaturen unter 100 °C, eingesetzt. Der besondere Wert der hohen Temperaturstabilität von LTCC in Zusammenhang mit der Zündung von Hochdruckentladungslampen, wie vor allem Metallhalogenidlampen mit Zündproblemen, ist im Stand der Technik nicht zu erkennen.

Der Spiral-Puls-Generator ist ein Bauteil, das Eigenschaften eines Kondensators mit denen eines Wellenleiters zur Erzeugung von Zündpulsen mit einer Spannung von mindestens 1,5 kV vereint, Für die Herstellung werden zwei keramische "Grün-Folien" mit metallischer Leitpaste bedruckt und anschließend versetzt zu einer Spirale aufgewickelt und schließlich isostatisch zu einem Formkörper gepresst. Die folgende Co-Sinterung von Metallpaste und keramischer Folie erfolgt an Luft im Temperaturbereich zwischen 800 und 1100°C, insbesondere im Bereich 800 bis 900°C. Diese Verarbeitung erlaubt einen Einsatzbereich des Spiral-Puls-Generators bis typisch 700°C Temperaturbelastung. Dadurch kann der Spiral-Puls-Generator in direkter Nähe des Entladungsgefäßes im Außenkolben, aber auch im Sockel oder in unmittelbarer Nähe der Lampe untergebracht werden.

Für die Herstellung von Spiral-Puls-Generatoren können aber auch keramische "Grünfolien" mit metallischer Leitpaste verwendet werden, die zum Bereich der Sintertemperaturen von HTCC-Materialien (High Temperature Co-fired Ceramics) gehören. Dies sind beispielsweise: Al₂O₃, ZrO₂ etc.. Diese Materialklasse wird im Hochtemperaturbereich zwischen 1100 und 1800°C dicht gesintert.

Die Sinterung kann auch in Stickstoff (N2), Argon (Ar), oder Wasserstoff (H2) oder Gemischen davon, mit unterschiedlichen Gaszusammensetzungen und Mischungsverhältnissen, erfolgen.

Für die Herstellung des Spiral-Puls-Generators können bevorzugt keramische Grünfolien verwendet werden, die nach der Sinterung eine relative Dielektrizitätskonstante (D.K.) epsilon (ε) von 5 bis 20000 aufweisen. Das ermöglicht eine sehr hohe Kapazität des Spiralkondensators, und außerdem eine vergleichsweise große Breite und Energie des erzeugten Hochspannungs-Impulses. Praktisch gute Werte für D.K. liegen bei ε = 10 bis 100.

Somit wird eine sehr kompakte Bauweise möglich, was den Einbau des Spiral-Puls-Generators direkt in den Außenkolben einer Lampe oder in deren Sockel ermöglicht. Die hohe Pulsbreite begünstigt außerdem den Durchschlag im Plasma des Entladungsgefäßes. Die hohe Energie erleichtert den Übergang zu einer selbstständigen Entladung.

Als Metallisierung auf der Folie eignen sich vorzugsweise alle Pastensysteme, die mindestens eine metallische Komponente haben und die nach dem Sinterprozess elektrischen Strom leiten. Dies sind vorzugsweise:
Ag, Au, Cu, Mo, Ni, Pt, Mischungen aus Ag und Pd gemäß der Zusammensetzung AgₓPd₁₋ₓ. Dabei ist x bevorzugt im Bereich 0,5 bis 0,99.

Die Metallisierung kann auch in Form von metallischen Folien auf die keramischen Substrate laminiert werden. Die Dicke der Folien liegt bevorzugt im Bereich 1 bis 100 µm. Dabei kann die Folie vor oder während des formgebenden Wickelprozesses aufgebracht werden.

Ein nichtmetallisches geeignetes Stoffsystem für eine leitfähige Beschichtung ist Graphit.

Ein nichtmetallisch-anorganisches Stoffsystem für eine leitfähige Beschichtung sind elektrisch leitfähige Keramiken oder Cermets.

Für die Herstellung von Spiral-Puls-Generatoren eignen sich grundsätzlich bevorzugt alle keramischen Stoffsysteme, aus denen über einen Schlicker keramische Grünfolien gezogen werden können. Die keramischen Stoffsysteme (nichtmetallisch-anorganisch) besitzen im Grundzustand eine D.K. zwischen εᵣ = 5 und εᵣ = 20000. Geeignet sind aber auch Stoffsysteme und Mischungen, in denen mindestens eine Komponente ein keramisches Stoffsystem darstellt. Dies sind insbesondere die Stoffe aus Tab. 1.

**Tab. 1**

| | |
|---|---|
| Material | D.K. εᵣ (ca.) |
| Keramische Substrate der LTCC-Technologie | 3 bis 10 000 |
| Übliche Materialien der Kondensatorfertigung | 10 bis 20 000 |
| Materialien aus der Gruppe Bariumtitanate sowie Ba-Sr-Titanate | 500 bis 12000, insb. 3000 bis 7000 |
| Materialien aus der Gruppe Barium-Zirkonat-Titanate | 15 000 bis 21 000 |
| Materialien aus der Gruppe Blei-Zirkonat-Titanate, sog. PZT, insb. harte und weiche PZT | 1 500 bis 2 500 |
| PZT mit Additiven | 8 000 bis 9 500 |
| Materialien aus der Gruppe Blei-Magnesium-Niobate, sog. PMN | 18 000 bis 20 000 |
| Materialien aus der Gruppe Blei-Zink-Niobate, sog. PZN | 17 000 bis 20 500 |
| Materialien aus der Gruppe Kalium-Natrium-Niobate, sog. KNN | 700 bis 1200 |
| Materialien aus der Gruppe Wismut-basierter Perowskite | 800 bis 1150 |
| Materialien aus der Gruppe Wolfram-Bronzen | 800 bis 1200 |

Die Vorteile einer derartigen Materialwahl sind:
- hohe Einsatztemperatur, so dass der Spiral-Puls-Generator in unmittelbarer Nähe der Lampe, in deren Sockel oder sogar in deren Außenkolben eingebaut werden kann;
- kleine Bauform;
- hochspannungsfeste Zuleitungen können entfallen;
- hohe Energiespeicherfähigkeit und daraus folgend hohe Zündpulsenergie;
- die Pulsbreite zum Starten einer Hochdruckentladungslampe kann in Abhängigkeit von der D.K. erhöht werden; typische resultierende Pulsbreiten sind 50 bis 200 ns.
- die Ladespannung kann in Abhängigkeit von der Wicklungszahl um den Faktor 5 bis 200 erhöht werden.

Ein konkreter Spiralpulsgenerator ist beispielsweise aus keramischem LTCC-Material gefertigt mit einem ε von 65. Die Tapelänge ist 50 cm bis 110 cm. Die Metallisierung ist eine Leitpaste aus Ag. Der resultierende Spiral-Puls-Generator hat beispielsweise einen Außendurchmesser von etwa 1,4 cm bis 2,5 cm.

Unabhängig davon kann ein derartiger Spiral-Puls-Generator auch für andere Anwendungen eingesetzt werden, weil er nicht nur hochtemperaturstabil ist, sondern auch äußerst kompakt. Dafür ist wesentlich, dass der Spiral-Puls-Generator als LTCC-Bauteil ausgeführt ist, bestehend aus Keramikfolien und metallischer Leitpaste. Um ausreichend Ausgangspannung zu liefern, sollte die Spirale mindestens 5 Windungen umfassen.

Zudem lässt sich auf Basis dieses Hochspannungspulsgenerators eine Zündeinheit angeben, die weiterhin zumindest einen Ladewiderstand und einen Schalter umfasst. Der Schalter kann eine Funkenstrecke oder auch ein Diac in SiC-Technologie sein.

Bevorzugt ist im Falle einer Anwendung für Lampen die Unterbringung im Außenkolben. Denn dadurch entfällt die Notwendigkeit einer hochspannungsfesten Spannungszuleitung.

Zudem lässt sich ein Spiral-Puls-Generator so dimensionieren, dass der Hochspannungspuls sogar eine Heißwiederzündung der Lampe ermöglicht. Das Dielektrikum aus Keramik zeichnet sich durch eine außergewöhnlich hohe Dielektrizitätskonstante εᵣ im Bereich von εᵣ > 10 aus, wobei je nach Material und Bauweise ein ε von typisch ε = 70 bis 100 erreicht werden kann. Das schafft eine sehr hohe Kapazität des Spiral-Puls-Generators und ermöglicht eine vergleichsweise große zeitliche Breite und hohe Energie der erzeugten Impulse. Dadurch wird eine sehr kompakte Bauweise des Spiral-Puls-Generators möglich, so dass ein Einbau in handelsübliche Außenkolben von Hochdruckentladungslampen gelingt.

Die große Pulsbreite erleichtert zudem den Durchschlag im Entladungsvolumen.

Als Material des Außenkolbens kann jedes übliche Glas verwendet werden, also insbesondere Hartglas, Vycor oder Quarzglas. Auch die Wahl der Füllung unterliegt keiner besonderen Einschränkung.

Bisher werden zwei Leiter verwendet, die in etwa dieselbe Breite besitzen. Um elektrische Überschläge zwischen den Leiterbahnen zu verhindern, werden deshalb die Stirnflächen der keramischen Spiralgeneratoren mit einer Isolationsschicht ausgestattet. Dies ist insbesondere eine Glasoder Harz-Schicht. Beispielsweise handelt es sich um sog. Overglass-Schicht oder eine Kunstharzschicht.

In einer bevorzugten Ausführungsform werden elektrische Überschläge eleganter vermieden und zwar unter Verzicht auf eine derartige zusäzliche Isolationsschicht. Dazu werden zwei Keramikfolien mit größerer Breite als die der Metallschichten verwendet. Auf der ersten Keramikfolie wird die erste Metallschicht als schmale Bahn aufgetragen. Auf der zweiten Keramikfolie wird die zweite schmale Metallschicht aufgetragen. Beim Laminieren fallen die überstehenden Keramikschichten zusammen und erreichen somit eine einfache Isolation der beiden Metallschichten an den stirnseitigen Enden des Spiralpulsgenerators.

Besonders bevorzugt ist eine Ausführungsform, bei der seitlich an den Metallshcihten noch ein Randsaum aus keramischem Isoliermaterial ohne Leitpaste verbleibt. Am besten wird dieser Randsaum mit einem Isoliermaterial beschichtet, anstatt der Leitpasten-Beschichtug. die Dicke dieser Schicht sollte ähnlich groß wie die der Leitpaste sein. Auf diese Weise wird ein Dickenunterschied im aufgewickelten System verhindert. Daher kann die Isolationsschicht nicht "Einfallen" und eine etwaige Schwächung des Randsaums wird verhindert, weil die Isolationsschicht einen Höhenausgleich des Randsaums leistet.

### Kurze Beschreibung der Zeichnungen

Im Folgenden soll die Erfindung anhand mehrerer Ausführungsbeispiele näher erläutert werden. Die Figuren zeigen:
- Fig. 1: den prinzipiellen Aufbau eines Spiral-Puls- Generators;
- Fig. 2: Kenngrößen eines LTCC- Spiral-Puls-Generators;
- Fig. 3: den Prinzipaufbau einer Hochdruckentladungslampe mit dritter Zünd-Elektrode mit einem Spiral-Puls- Generator im Außenkolben.
- Fig. 4: den Prinzipaufbau einer Hochdruckentladungslampe mit Überlagerungszündung, mit Spiral-Puls- Generator im Außenkolben.
- Fig. 5: eine Metallhalogenidlampe mit Spiral-Puls- Generator im Außenkolben;
- Fig. 6: eine Metallhalogenidlampe mit Spiral-Puls- Generator im Sockel.
- Fig. 7: einen Spiral-Puls-Generator mit eingebauter Fun- kenstrecke;
- Fig. 8: einen Spiralpulsgenerator mit stirnseitiger Iso- lierschicht;
- Figur 9: einen Spiralpulsgenerator mit einfachem "einge- fallenem" Randsaum;
- Figur 10: einen Spiralpulsgenerator mit Höhenausgleich des Randsaums.

### Bevorzugte Ausführungsform der Erfindung

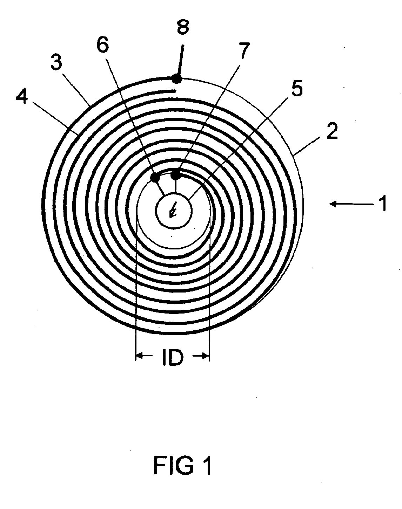

Figur 1 zeigt den Aufbau eines Spiral-Puls-Generators 1 in Draufsicht. Er besteht aus einem keramischen Zylinder 2, in den zwei verschiedene metallische Leiter 3 und 4 spiralförmig eingewickelt sind. Der Zylinder 2 ist innen hohl und besitzt einen gegebenen Innendurchmesser ID. Die beiden inneren Kontakte 6 und 7 der beiden Leiter 3 und 4 liegen benachbart und sind über eine Funkenstrecke 5 miteinander verbunden.

Nur der äußere der beiden Leiter besitzt am äußeren Rand des Zylinders einen weiteren Kontakt 8. Der andere Leiter endet offen. Die beiden Leiter bilden zusammen einen Wellenleiter mit einem offenen Ende, wobei der Wellenleiter in einem dielektrischen Medium, der Keramik, realisiert ist.

Der Spiral-Puls-Generator wird entweder aus zwei mit Metallpaste beschichteten keramischen Folien gewickelt oder aus zwei Metallfolien und zwei keramischen Grünfolien aufgebaut. Eine wichtige Kenngröße ist dabei die Zahl n der Windungen, die bevorzugt in der Größenordnung 5 bis 100 liegen soll. Diese Wickelanordnung wird laminiert und anschließend co-gesintert, wodurch ein keramisches Bauteil, insbesondere ein LTCC-Bauteil oder auch HTCC-Bauteil, entsteht. Die so geschaffenen Spiral-Puls-Generatoren mit Kondensatoreigenschaft werden dann mit einer Funkenstrecke sowie einem Ladewiderstand beschaltet.

Die Funkenstrecke kann sich an den inneren oder den äußeren Anschlüssen oder auch innerhalb der Wicklung des Generators befinden. Als Hochspannungsschalter, der den Puls initiiert, kann bevorzugt eine Funkenstrecke verwendet werden. Weiterhin ist die Verwendung eines hochtemperaturfesten Halbleiterschalters, bevorzugt in SiC-Technologie, möglich. Dieser ist für Temperaturen bis 350°C geeignet.

In einem konkreten Ausführungsbeispiel wird ein Keramikmaterial mit ε = 60 bis 70 verwendet. Dabei wird bevorzugt als Dielektrikum eine Keramikfolie, insbesondere ein Keramikband wie Heratape CT 700 oder CT 707 oder bevorzugt CT 765, jeweils von Heraeus, oder auch eine Mischung von mindestens zweien davon verwendet. Die Dicke der grünen Folie beträgt typisch 50 bis 150 µm. Als Leiter wird insbesondere Ag-Leitpaste wie "Cofirable Silver," ebenfalls von Heraeus, verwendet. Ein konkretes Beispiel ist TC 7303 von Heraeus. Gute Ergebnisse liefert auch die Metallpaste 6142 von DuPont. Diese Teile lassen sich gut laminieren und danach ausheizen ("binder burnout") und zusammen sintern ("co-firing").

Der Innendurchmesser ID des konkreten Spiral-Puls-Generator ist 10-14 mm. Die Breite der einzelnen Keramik-Streifen ist etwa 6 bis 9 mm. Die Breite des Leiters ist um 1 bis 4 mm geringer als die Breite der Keramikfolien. Die Foliendicke ist 50-80 µm und die Dicke der beiden Leiter ist jeweils 7 bis 12 µm. Bei einer Ladespannung von 300 V generiert dieser Generator 2500 V. Unter diesen Voraussetzungen erreicht der Spiral-Puls-Generator ein Optimum seiner Eigenschaften bei einer Windungszahl von etwa n = 19.

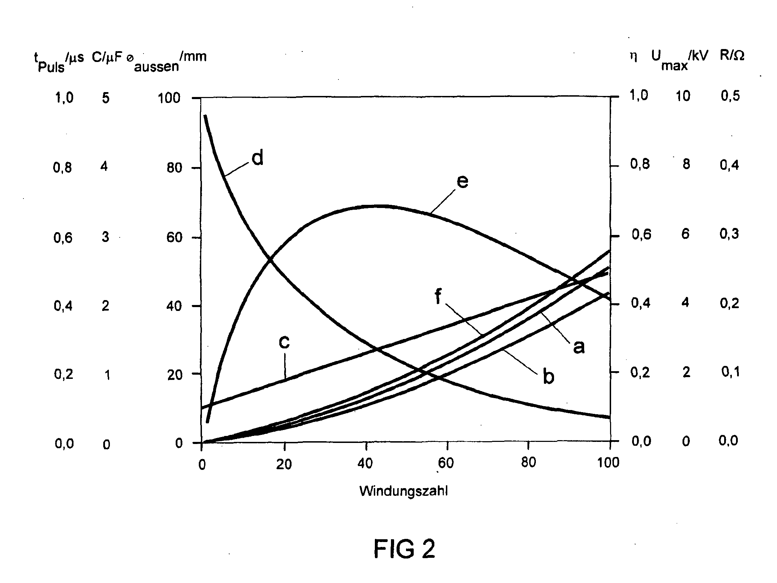

In Figur 2 sind die zugehörige Halbwertsbreite des Hochspannungspulses in µs (Kurve a), die Gesamtkapazität des Bauteils in µF (Kurve b), der resultierende Außendurchmesser in mm (Kurve c), sowie die Effizienz (Kurve d), die maximale Pulsspannung (Kurve e) in kV und der Leiterwiderstand in Q (Kurve f) dargestellt.

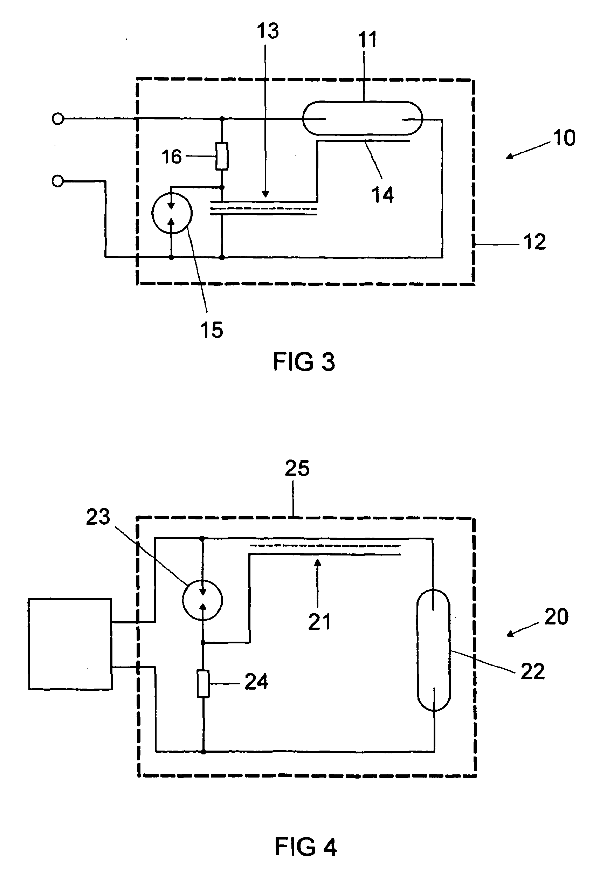

Figur 3 zeigt den prinzipiellen Aufbau einer Hochdruckentladungslampe, insbesondere einer Natriumhochdrucklampe 10, mit keramischem Entladungsgefäß 11 und Außenkolben 12 mit darin integriertem Spiral-Puls-Generator 13, wobei eine Zünd-Elektrode 14 außen am keramischen Entladungsgefäß 11 angebracht ist. Der Spiral-Puls-Generator 13 ist mit der Funkenstrecke 15 und dem Ladewiderstand 16 im Außenkolben untergebracht.

Figur 4 zeigt den prinzipiellen Aufbau einer Hochdruckentladungslampe, insbesondere einer Metallhalogenidlampe 20, mit integriertem Spiral-Puls-Generator 21, wobei keine Zünd-Elektrode außen am Entladungsgefäß 22, das aus Quarzglas oder Keramik gefertigt sein kann, angebracht ist. Der Spiral-Puls-Generator 21 ist mit der Funkenstrecke 23 und dem Ladewiderstand 24 im Außenkolben 25 untergebracht. Der Hochspannungspuls wird der Betriebsspannung der Lampe überlagert und über eine Hauptelektrode zugeführt.

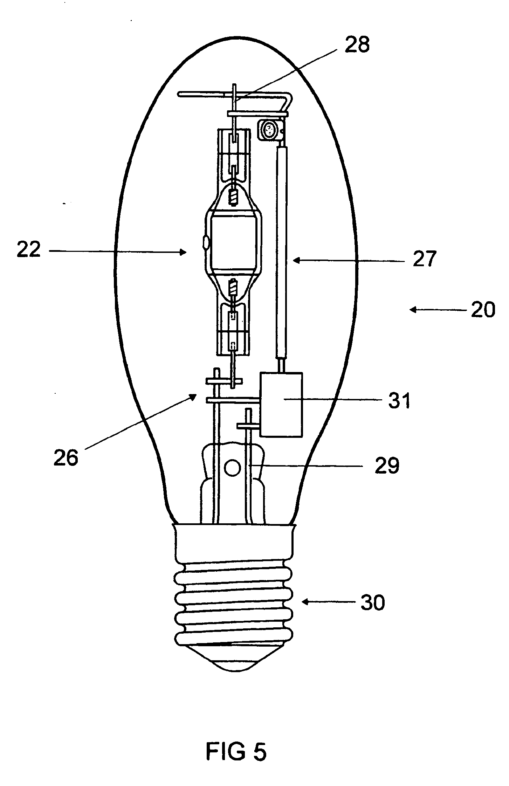

Figur 5 zeigt eine Metallhalogenidlampe 20 mit einem Entladungsgefäß 22, das von zwei Zuleitungen 26, 27 in einem Außenkolben gehaltert wird. Die erste Zuleitung 26 ist ein kurz abgewinkelter Draht. Die zweite 27 ist im wesentlichen ein Stab, der zur sockelfernen Durchführung 28 führt. Zwischen der Zuleitung 29 aus dem Sockel 30 und dem Stab 27 ist eine Zündeinheit 31 angeordnet, die den Spiral-Puls-Generator, die Funkenstrecke und den Ladewiderstand enthält, wie in Figur 4 angedeutet.

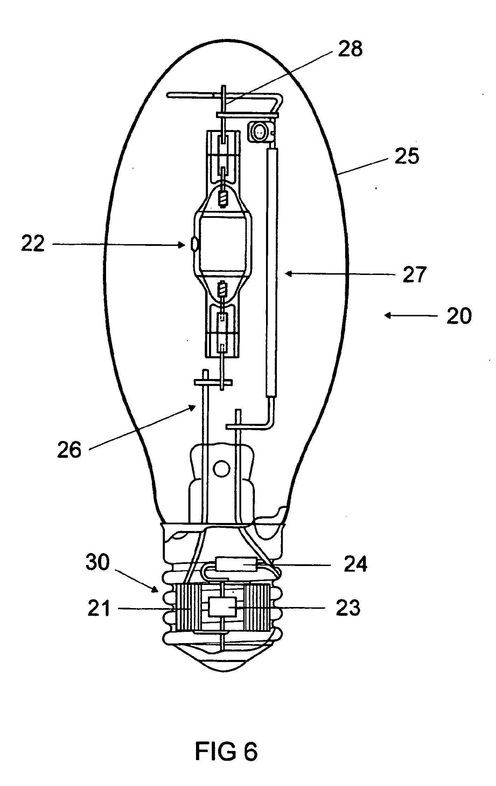

Figur 6 zeigt eine Metallhalogenidlampe 20 ähnlich wie Figur 5 mit einem Entladungsgefäß 22, das von zwei Zuleitungen 26, 27 in einem Außenkolben 25 gehaltert wird. Die erste Zuleitung 26 ist ein kurz abgewinkelter Draht. Die zweite 27 ist im wesentlichen ein Stab, der zur sockelfernen Durchführung 28 führt. Hier ist die Zündeinheit im Sockel 30 angeordnet, und zwar sowohl der Spiral-Puls-Generator 21, als auch die Funkenstrecke 23 und der Ladewiderstand 24.

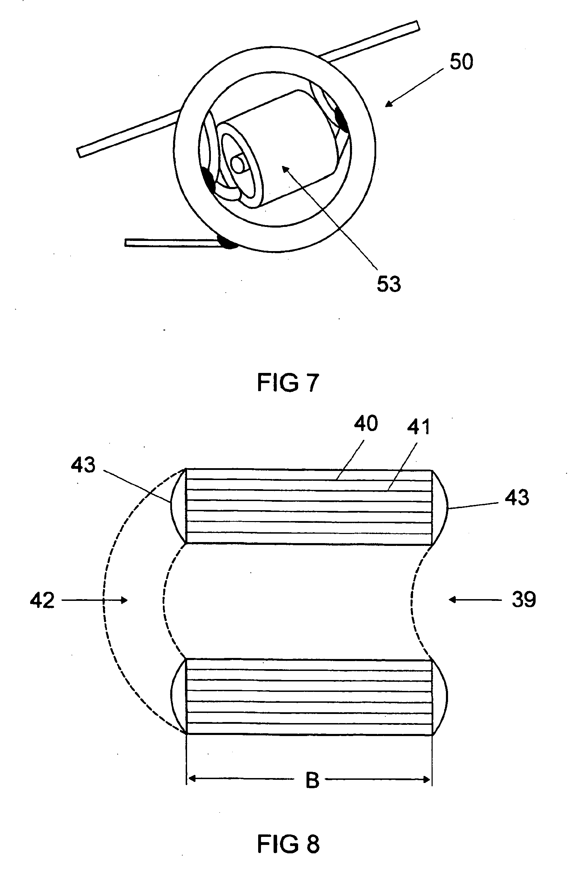

Figur 7 zeigt die körperliche Realisierung eines Spiral-Puls-Generators 50 mit eingebauter Funkenstrecke 53. Er besitzt zwei elektrische Anschlüsse im Inneren an der Funkenstrecke 53 und einen Anschluss am äußeren Umfang.

Figur 8 zeigt einen keramischen Spiralpulsgenerator 39 mit Isolation der Stirnflächen im Querschnitt. Schematisch sind einige Schichten der Wicklung angedeutet, wobei zwei verschiedene Metallleiter 40 und 41 ineinander gewickelt sind. Am Rand des keramischen Bandes mit der Breite B, also an der als Kreisring geformten Stirnseite 42 reichen hier die metallischen Leiter 40 und 41 bis direkt zum Rand. Eine Isolierschicht 43 ist wie eine Kuppe (im Querschnitt gesehen) darauf angebracht und isoliert die zwei Metallleiter gegeneinander und verhindert eine Gleitentladung über die Keramikschicht.

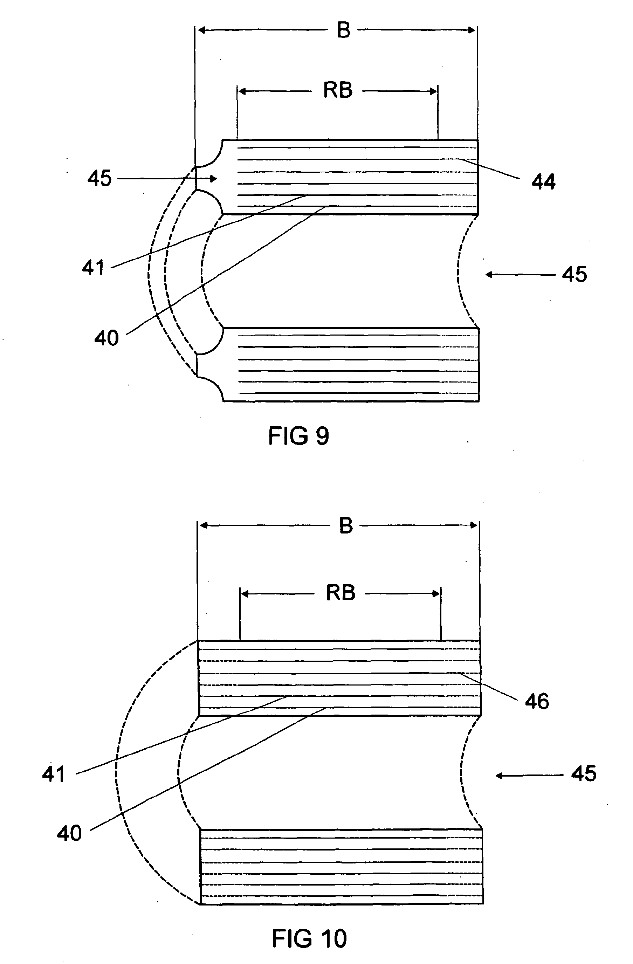

Ein weiteres Ausführungsbeispiel ist in Figur 9 gezeigt. Dort hat der Spiralpulsgenerator 45 zwei Metalleiter 40, 41, deren Schicht nicht die volle Breite B des keramischen Bandes ausnützt, sondern deutlich innerhalb davon endet (rechte Hälfte). Die reduzierte Breite RB liegt vorteilhaft bei RB = B - X, wobei X = 1 bis 4 mm. Das verbessert auf einfachste Weise die Isolation ohne die Notwendigkeit einer Isolierschicht, führt jedoch bei relativ kleinem RB zu Hohlräumen 44 im Randgebiet, die einfallen können. Auf der linken Seite ist ein derart eingefallenes Randgebiet 45 gezeigt. Dieser Vorgang begrenzt die Lebensdauer und Stabilität des Spiralpulsgenerators. Dieser Aufbau kann daher nur bei sehr dünnen Isolierschichten angewendet werden.

Figur 10 zeigt eine verbesserte Version eines Spiralpulsgenerators 45, bei der nach wie vor wie in Figur 9 zwei Metalleiter 40, 41 nicht die volle Breite B des keramischen Bandes ausnützen. Jedoch ist hier der randseitige Hohlraum mit der Breite X = B - RB vollständig oder teilweise, bevorzugt zu mindestens 80 %, statt mit dem Metallleiter mit einem Isoliermaterial 46 ungefähr gleicher Dicke wie die der Metallleiter 40, 41 ausgefüllt. Als Material kommt das Material des keramischen Bandes oder ein gleichwertiges Material in Frage. Auf diese Weise gibt es praktisch keinen Hohlraum und damit auch kein Einfallen des Randgebiets.

Die verschiedenen Mittel zum Isolieren können auch miteinander kombiniert werden, so dass beispielsweise eine stirnseitige Isolierfläche mit einer reduzierten Breite der Metallschicht zusammenwirkt. Es kann auch nur eine der beiden Metallschichten eine reduzierte Breite RB, verglichen mit der Breite B der Keramikfolien besitzen, ggf. kombiniert mit einer stirnseitigen Isolierfläche. Außerdem können auch zwei Keramikfolien unterschiedlicher Breite verwendet werden.

Die Erfindung entfaltet besondere Vorteile im Zusammenwirken mit Hochdruckentladungslampen für Autoscheinwerfer, die mit Xenon unter hohem Druck von bevorzugt mindestens 3 bar und Metallhalogeniden gefüllt sind. Diese sind besonders schwer zu zünden, da wegen des hohen Xenondrucks die Zündspannung mehr als 10 kV beträgt. Derzeit wird versucht, die Komponenten der Zündeinheit im Sockel unterzubringen. Ein Spiral-Puls-Generator mit integriertem Ladewiderstand kann entweder in den Sockel der Kfz-Lampe oder in einen Außenkolben der Lampe untergebracht sein.

Die Erfindung entfaltet ganz besondere Vorteile im Zusammenwirken mit Hochdruckentladungslampen, die kein Quecksilber enthalten. Derartige Lampen sind aus Umweltschutzgründen besonders erstrebenswert. Sie enthalten eine geeignete Metallhalogenid-Füllung und insbesondere ein Edelgas wie Xenon unter hohem Druck. Wegen des fehlenden Quecksilbers ist die Zündspannung besonders hoch. Sie beträgt typisch mindestens 5 kV, kann aber auch mehr als 20 kV betragen. Derzeit wird versucht, die Komponenten der Zündeinheit im Sockel unterzubringen. Ein Spiral-Puls-Generator mit integriertem Ladewiderstand kann entweder in den Sockel der Quecksilberfreien Lampe oder in einen Außenkolben der Lampe untergebracht sein.

## Patentansprüche

1. Kompakter Hochspannungspulsgenerator auf der Basis eines Spiral-Puls-Generators, **dadurch gekennzeichnet, dass** der Spiral-Puls-Generator als LTCC-Bauteil oder HTCC-Bauteil aus zwei Keramikfolien gegebener Breite B und einem jeweils darauf aufgebrachten metallischen Leiter aufgebaut ist, die zusammen spiralig aufgewickelt sind, so dass der Rand der Folien zusammen eine kreisringartige Stirnfläche bildet, wobei die beiden Leiter durch mindestens ein Mittel zum Isolieren voneinander elektrisch isoliert sind.

2. Hochspannungspulsgenerator nach Anspruch 1, **dadurch gekennzeichnet, dass** das Mittel zum Isolieren eine isolierende Beschichtung auf der Stirnfläche ist.

3. Hochspannungspulsgenerator nach Anspruch 1, **dadurch gekennzeichnet, dass** das Mittel zum Isolieren eine reduzierte Breite RB mindestens eines Metallleiters, verglichen mit der vollen Breite B der Keramikfolien, ist.

4. Hochspannungspulsgenerator nach Anspruch 3, **dadurch gekennzeichnet, dass** der durch die reduzierte Breite gebildete Hohlraum durch eine isolierende Beschichtung mindestens teilweise ausgefüllt ist.

5. Hochspannungspulsgenerator nach Anspruch 1, **dadurch gekennzeichnet, dass** die Anzahl der Windungen der Keramischen Folien mindestens n = 5 und bevorzugt höchstens n = 500 Windungen umfasst.

6. Hochspannungspulsgenerator nach Anspruch 1, **dadurch gekennzeichnet, dass** die Keramikfolie mindestens ein Material aus der Gruppe der Titanate oder Niobate, der Wismut-basierten Perowskite oder der Wolfram-Bronzen verwendet.

7. Hochspannungspulsgenerator nach Anspruch 6, **dadurch gekennzeichnet, dass** die Dielektrizitätskonstante des Materials zwischen 3 und 21 000, bevorzugt zwischen 5 und 2000, gewählt ist.

8. Zündvorrichtung auf Basis eines Hochspannungspulsgenerators nach Anspruch 1, **dadurch gekennzeichnet, dass** sie weiterhin zumindest einen Ladewiderstand und einen Schalter umfasst.

9. Hochdruckentladungslampe mit einem Entladungsgefäß, das in einem Außenkolben untergebracht ist und dort durch ein Gestell gehaltert ist, wobei eine Zündvorrichtung nach Anspruch 8 in der Lampe integriert ist.

10. Hochdruckentladungslampe nach Anspruch 9, **dadurch**
**gekennzeichnet, dass** der Spiral-Puls-Generator in etwa hohlzylindrische Gestalt hat, mit einem Innendurchmesser von mindestens 10 mm.

## Claims

1. Compact high-voltage pulse generator based on a spiral pulse generator, **characterized in that** the spiral pulse generator is in the form of an LTTC component part or HTCC component part comprising two ceramic films of a given width B and a metallic conductor applied to each of said ceramic films, which conductors are wound together in spiral form, with the result that the edge of the films together forms an end face in the manner of a circular ring, the two conductors being electrically insulated from one another by at least one insulation means.

2. High-voltage pulse generator according to Claim 1, **characterized in that** the insulation means is an insulating coating on the end face.

3. High-voltage pulse generator according to Claim 1, **characterized in that** the insulation means is a reduced width RB of at least one metal conductor in comparison with the full width B of the ceramic films.

4. High-voltage pulse generator according to Claim 3, **characterized in that** the cavity formed by the reduced width is at least partially filled with an insulating coating.

5. High-voltage pulse generator according to Claim 1, **characterized in that** the number of turns of the ceramic films comprises at least n = 5 and preferably at most n = 500 turns.

6. High-voltage pulse generator according to Claim 1, **characterized in that** the ceramic film uses at least one material from the group of titanates or niobates, of bismuth-based perovskites or tungsten bronzes.

7. High-voltage pulse generator according to Claim 6, **characterized in that** the dielectric constant of the material is selected to be between 3 and 21 000, preferably between 5 and 2000.

8. Starting apparatus based on a high-voltage pulse generator according to Claim 1, **characterized in that** it furthermore comprises at least one charging resistor and a switch.

9. High-pressure discharge lamp with a discharge vessel which is accommodated in an outer bulb and is held there by a frame, a starting apparatus according to Claim 8 being integrated in the lamp.

10. High-voltage discharge lamp according to Claim 9, **characterized in that** the spiral pulse generator has an approximately hollow-cylindrical design, with an inner diameter of at least 10 mm.

## Revendications

1. Générateur compact d'impulsions à haute tension sur la base d'un générateur d'impulsions à spirale, **caractérisé en ce que** le générateur d'impulsions à spirale est conçu en tant que composant LTCC ou composant HTCC à partir de deux feuilles céramiques de largeur donnée B et d'un conducteur métallique respectivement appliqué dessus, lesquels sont enroulés ensemble en spirale, de sorte que le bord des feuilles forme ensemble une surface frontale en forme d'anneau circulaire, les deux conducteurs étant isolés électriquement par au moins un moyen pour les isoler l'un de l'autre.

2. Générateur d'impulsions à haute tension selon la revendication 1, **caractérisé en ce que** le moyen d'isolation est un revêtement isolant sur la surface frontale.

3. Générateur d'impulsions à haute tension selon la revendication 1, **caractérisé en ce que** le moyen d'isolation est une largeur réduite RB au moins d'un conducteur métallique, comparée avec la largeur complète B des feuilles céramiques.

4. Générateur d'impulsions à haute tension selon la revendication 3, **caractérisé en ce que** l'espace creux formé par la largeur réduite est rempli au moins en partie par un revêtement isolant.

5. Générateur d'impulsions à haute tension selon la revendication 1, **caractérisé en ce que** le nombre des enroulements des feuilles céramiques comprend au moins n = 5 et de préférence au maximum n = 500 enroulements.

6. Générateur d'impulsions à haute tension selon la revendication 1, **caractérisé en ce que** la feuille céramique utilise au moins un matériau provenant du groupe des titanates ou des niobates, des perovskites à base de bismuth ou des bronzes au tungstène.

7. Générateur d'impulsions à haute tension selon la revendication 6, **caractérisé en ce que** la constante diélectrique du matériau est sélectionnée entre 3 et 21 000, de préférence entre 5 et 2000.

8. Dispositif d'allumage sur la base d'un générateur d'impulsions à haute tension selon la revendication 1, **caractérisé en ce qu'**il comprend en outre au moins une résistance de charge et un commutateur.

9. Lampe à décharge à haute tension comprenant un récipient de décharge qui est logé dans une ampoule extérieure et y est maintenu par un support, un dispositif d'allumage selon la revendication 8 étant intégré dans la lampe.

10. Lampe à décharge à haute tension selon la revendication 9, **caractérisée en ce que** le générateur d'impulsions à spirale a à peu près une forme cylindrique creuse, avec un diamètre intérieur d'au moins 10 mm.
